Europäisches Patentamt

European Patent Office

Office européen des brevets

(19)

(11) Numéro de publication : **0 511 886 A1**

## (12) DEMANDE DE BREVET EUROPEEN

(21) Numéro de dépôt : **92400995.4**

(22) Date de dépôt : **09.04.92**

(51) Int. Cl.⁵ : **H03H 11/20**

(30) Priorité : **29.04.91 FR 9105236**

(43) Date de publication de la demande :
**04.11.92 Bulletin 92/45**

(84) Etats contractants désignés :
**DE GB IT SE**

(71) Demandeur : **AGENCE SPATIALE EUROPEENNE**
**Organisation Intergouvernementale, 8-10, rue Mario Nikis**
**F-75738 Paris Cedex 15 (FR)**

(72) Inventeur : **Petz, Felix Anton**
**De Ruyterstraat 51**
**NL-2202 KH Noordwijk (NL)**

(74) Mandataire : **Rodhain, Claude et al**
**Cabinet Claude Rodhain 30, rue la Boétie**
**F-75008 Paris (FR)**

(54) **Circuit déphaseur à modulation vectorielle.**

(57)    Un tel circuit déphaseur comprend :

— un circuit diviseur (10), recevant en entrée (1) un signal à déphaser et fractionnant celui-ci en deux signaux en quadrature délivrés sur deux sorties respectives,

— monté sur chacune des sorties du circuit diviseur, un circuit de modulation vectorielle (20 ; 30), soumettant le signal fractionné respectif à une atténuation variable et à une inversion de phase éventuelle, et

— un circuit combineur (40), recevant sur ses entrées les signaux délivrés par les circuits de modulation vectorielle respectifs et délivrant sur sa sortie (3) le signal déphasé.

Selon l'invention, chacun des circuits de modulation vectorielle (20 ; 30) est essentiellement constitué d'un atténuateur du type réflectif comprenant des moyens d'ajustement d'une valeur algébrique de l'atténuation, de manière à agir par une même commande sur l'amplitude et l'inversion éventuelle de phase du signal reçu en entrée, par exemple un coupleur à quatre accès, avec un premier accès constituant l'entrée, un second accès constituant la sortie et les deux autres accès constituant des accès de commande reliés à deux charges résistives semblables, par exemple un montage différentiel de transistors à effet de champ, ces charges étant variables et contrôlées par la même commande.

FIG_1

EP 0 511 886 A1

L'invention concerne un circuit déphaseur à modulation vectorielle.

Dans un tel circuit, un signal d'entrée est fractionné (décomposition vectorielle) en deux signaux de même amplitude mais en quadrature, par exemple au moyen d'un coupleur hybride 3 dB, et chacun des deux signaux résultants est soumis pour sa part à une atténuation variable et à une inversion de phase éventuelle ; les deux signaux ainsi traités sont ensuite recombinés (sommation vectorielle) pour donner le signal de sortie présentant le déphasage voulu. Une atténuation globale d'amplitude peut en outre compléter éventuellement ce déphasage.

De très nombreux concepts ont été développés, qu'ils soient basés sur des procédés numériques, analogiques ou mixtes. Par exemple, dans le cas d'une technologie microruban, les techniques les plus couramment utilisées sont la ligne à retard commutée, le filtre passe-haut/passe-bas commuté et le modulateur vectoriel. Parmi les autres techniques utilisées, on peut citer l'amplification répartie, les transistors à effet de champ à double grille, les déphaseurs à ferrite, les diodes PIN et à capacité variable, les lignes chargées, etc.

Ces différents concepts sont notamment exposés et comparés par Arvind K. Sharma dans *Solid-State Control Devices : State of the Art*, in *Microwave Journal Supplement*, Sept. 1989, pp. 95-112.

La réalisation des déphaseurs de ce type est généralement assez complexe et les performances obtenues ne sont guère satisfaisantes, ni en ce qui concerne la stabilité à l'égard des variations de température, ni en ce qui concerne les pertes d'insertion.

Concernant ce dernier point, les pertes d'insertion élevées imposent généralement une compensation par un étage amplificateur supplémentaire, consommateur d'énergie.

Cet inconvénient est particulièrement gênant lorsque ces déphaseurs sont utilisés pour des radars dits « à ouverture synthétique » (radars à balayage et conformation électroniques de faisceau) ; les antennes de ces radars comportent en effet couramment plusieurs centaines de modules émetteurs/récepteurs, chacun équipé de son propre circuit de commande de phase et d'amplitude.

On comprend alors que la consommation énergétique, les pertes d'insertion, la stabilité, la complexité de conception, de fabrication et de montage des circuits, leur fiabilité, etc., soient des paramètres majeurs lorsque l'on souhaite obtenir des performances satisfaisantes à un coût non rédhibitoire.

Or, toutes les méthodes utilisées jusqu'à présent pour réaliser la variation de phase sont fortement consommatrices d'énergie, la seule exception notable étant celle des systèmes du type à ligne à retard commutée, qui ne nécessitent pas d'apport énergétique important lorsqu'ils utilisent des organes de commutation à transistors à effet de champ polarisés autour d'une tension nulle; toutefois, les dispositifs réalisés présentent une homogénéité de performances médiocre d'un circuit à l'autre, et leurs pertes d'insertion varient selon que l'on commute ou non l'inversion de phase du signal.

Un circuit de ce type est par exemple proposé par Charles Suckling dans *Phase Shifters Using GaAs Monolithic Circuits*, in *Allen Clark Research Centre Annual Review*, 1982, pp. 49-53. Dans le circuit décrit dans cet article, chacune des deux branches de modulation vectorielle comporte un circuit atténuateur variable monté en série avec un circuit inverseur de phase commutable à deux états (avec ou sans inversion de phase). Selon l'état des commutations, le circuit combineur recevra et sommera deux vecteurs, d'amplitude variable selon l'atténuation qui leur a été appliquée, et présentant entre eux un déphasage de 0°, 90°, 180° ou 270°. La composition de ces vecteurs donnera une résultante dont la phase pourra varier continûment entre 0° et 360°. Ce circuit présente comme inconvénients de comporter un composant actif (le diviseur) et le fait que le déphaseur utilisé introduit des pertes d'insertion supplémentaires.

L'un des buts de l'invention est donc de proposer un circuit déphaseur à modulation vectorielle présentant une faible perte d'insertion (typiquement, de l'ordre de 6 dB seulement, comparable à celle des circuits classiques à ligne à retard commutée), qui ne nécessite donc pas d'amplification compensatrice - en d'autres termes, un circuit qui soit essentiellement passif - et de faible complexité de structure (nombre réduit de composants).

On verra cependant que, malgré sa simplicité, le déphaseur de l'invention présente des performances électriques au moins identiques, sinon meilleures (notamment en ce qui concerne la stabilité à la température), que les circuits antérieurs de conception différente.

Le circuit déphaseur de l'invention est, comme on l'a indiqué plus haut, un circuit du type à modulation vectorielle, c'est-à-dire un circuit comprenant: un circuit diviseur, recevant en entrée un signal à déphaser et fractionnant celui-ci en deux signaux en quadrature délivrés sur deux sorties respectives ; monté sur chacune des sorties du circuit diviseur, un circuit de modulation vectorielle, soumettant le signal fractionné respectif à une atténuation variable et à une inversion de phase éventuelle ; et un circuit combineur, recevant sur ses entrées les signaux délivrés par les circuits de modulation vectorielle respectifs et délivrant sur sa sortie le signal déphasé.

Le circuit de l'invention est caractérisé en ce que chacun des circuits de modulation vectorielle est essentiellement constitué d'un atténuateur du type réflectif comprenant des moyens d'ajustement d'une valeur algébrique de l'atténuation, de manière à agir par une même commande sur l'amplitude et l'inversion éventuelle de phase du signal reçu en entrée.

Dans un mode de réalisation avantageux, l'atténuateur réflectif comprend un coupleur à quatre accès, avec un premier accès constituant l'entrée, un second accès constituant la sortie et les deux autres accès constituant des accès de commande reliés à deux charges résistives semblables, ces charges étant variables et contrôlées par la même commande, par exemple sous forme d'un montage différentiel de transistors à effet de champ commandés en tension, et dont les bornes homologues sont reliées'aux accès de commande respectifs du coupleur ; dans ce dernier cas, il est de préférence prévu un circuit de linéarisation de la variation de résistance en fonction de la tension de commande des transistors à effet de champ.

On va maintenant décrire un exemple de réalisation de l'invention, en référence aux dessins annexés.

La figure 1 est une représentation schématique du circuit déphaseur de l'invention.

La figure 2 est un diagramme vectoriel montrant les différentes possibilités de modulation en fonction des commandes appliquées au déphaseur.

La figure 3 montre une réalisation monolithique intégrée du circuit schématisé figure 1.

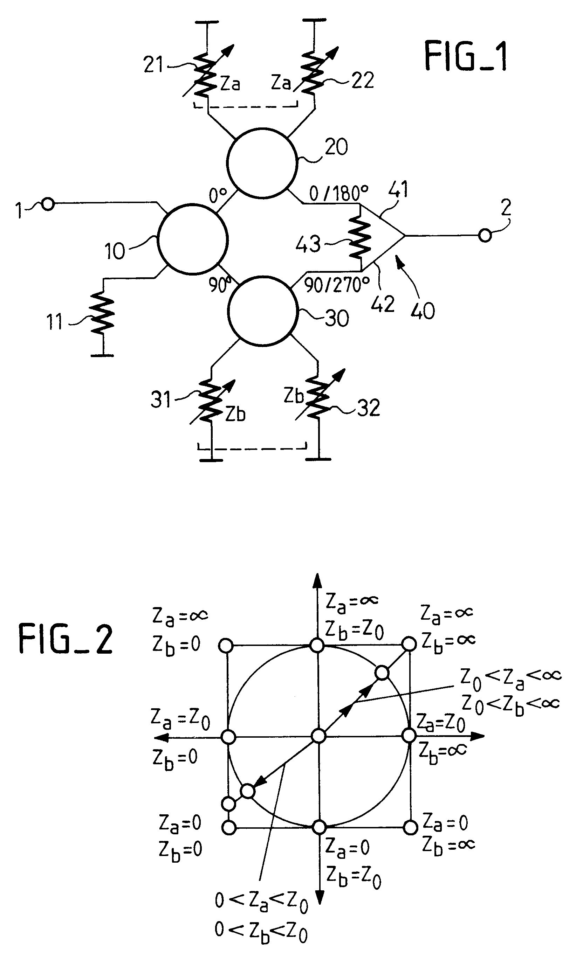

Sur la figure 1, on a représenté schématiquement le circuit déphaseur de l'invention, qui comporte une entrée 1 et une sortie 2. Ce circuit est essentiellement un circuit passif, ne nécessitant pas d'apport d'énergie extérieure, et il présente en outre la propriété d'être bidirectionnel, c'est-à-dire que le rôle de l'entrée et celui de la sortie peuvent être inversés.

Ce déphaseur comporte, essentiellement, un circuit diviseur 10, par exemple un coupleur hybride 3 dB de type classique recevant sur l'un de ses accès le signal d'entrée appliqué en 1 et délivrant sur deux autres accès deux signaux en quadrature (à 0° et 90° par rapport au signal appliqué en 1), le quatrième accès du coupleur 10 étant simplement chargé par une résistance 11. Chacun des deux signaux en quadrature est appliqué à un modulateur vectoriel respectif 20, 30 modifiant l'amplitude et, éventuellement, la phase (inversion de phase ou non) du signal appliqué en entrée : ainsi, en sortie du circuit 20, on retrouve un signal d'amplitude variable et déphasé de 0° ou 180° par rapport au signal appliqué sur l'entrée 1 et, en sortie du circuit 30, un signal d'amplitude variable et déphasé de 90° ou de 270° par rapport au signal appliqué sur l'entrée 1. Ces deux signaux sont alors recomposés par un circuit 40, par exemple un circuit combineur du type Wilkinson à trois branches comportant deux lignes 41 et 42 montées en triangle de part et d'autre d'une branche résistive 43.

La caractéristique essentielle réside dans la structure particulière de chacun des circuits de modulation vectorielle 20, 30, qui sont constitués par des atténuateurs variables réflectifs, par exemple formés d'un coupleur à quatre accès avec deux accès adjacents chargés par une résistance variable 21, 22 ou 31, 32, de même valeur pour les deux accès ($Z_a$ dans le cas du circuit 20, $Z_b$ dans le cas du circuit 30), et telles que la valeur $Z_a$ ou $Z_b$ puisse prendre des valeurs situées aussi bien en deçà qu'au-delà de l'impédance caractéristique $Z_o$ du coupleur.

Le signal appliqué en entrée sur l'un des accès du coupleur se trouve donc injecté dans les résistances variables $Z_a$ ou $Z_b$ et partiellement rétroréfléchi dans le coupleur, puis renvoyé en sortie sur le quatrième accès du coupleur, en direction du combineur 40. En faisant varier la valeur de $Z_a$ ou de $Z_b$, on peut non seulement agir sur l'amplitude du signal obtenu en sortie, mais également sur sa phase : en effet, de façon typique d'un tel circuit, si $Z_a$ ou $Z_b$ est supérieur à l'impédance caractéristique $Z_o$ du coupleur, le signal recueilli en sortie est en phase avec le signal appliqué en entrée ; mais si cette valeur est inférieure à $Z_o$, le signal est en opposition de phase.

En d'autres termes, la commande de chaque circuit de modulation vectorielle permet non seulement de faire varier l'amplitude du signal entre 0 et 100 % de la valeur appliquée en entrée, mais aussi d'inverser ou non sa phase.

Globalement, après sommation par le combineur 40 des deux signaux modulés, on voit que l'on recueille sur la sortie 2 un signal homologue du signal appliqué à l'entrée 1, mais dont l'amplitude peut varier entre 0 et 100% de l'amplitude d'origine (aux pertes d'insertion près, de l'ordre de quelques décibels) et dont la phase peut être variée d'une valeur quelconque comprise entre 0° et 360°.

En termes mathématiques, la fonction de transfert du circuit de la figure 1 est donnée par :

$$\frac{V_{out}}{V_{in}} = 0,5 \, A \, e^{i\Phi},$$

avec :

$$A = \left[ \left(\frac{Z_a - Z_b}{Z_a + Z_b}\right)^2 + \left(\frac{Z_b - Z_o}{Z_b + Z_o}\right)^2 \right]^{1/2}, \text{ et}$$

$$\Phi = \left( \text{arctg} \, \frac{Z_a - Z_o}{Z_b - Z_o} \cdot \frac{Z_b + Z_o}{Z_a + Z_o} \right) + 180 \cdot \text{sign} \, (Z_a - Z_o).$$

Sur la figure 2, on a représenté dans le plan vectoriel les différentes possibilités de modulation pour des valeurs de $Z_a$ et $Z_b$ variant, entre zéro et l'infini, en deçà et au-delà de l'impédance caractéristique $Z_o$.

Du point de vue de la réalisation pratique, il est souhaitable, pour éviter une dégradation du ROS et pour une bonne conformité de la fonction de transfert avec son expression mathématique donnée plus haut, que les résistances 21, 22 et 31, 32 de chacun des circuits de modulation vectorielle soient appariées au mieux dans chaque branche.

Lorsque l'on utilise des échelles de résistances commutées, cet appariement n'est généralement pas problématique, à condition de procéder à une sélection soigneuse des composants utilisés. Mais on peut aussi avantageusement utiliser, au lieu de ces échelles de résistances commutées, des composants à effet de champ commandés en tension, dont l'appariement sera garanti s'il s'agit de composants différentiels réalisés sur une même puce, comme cela est en particulier le cas avec les circuits intégrés monolithiques.

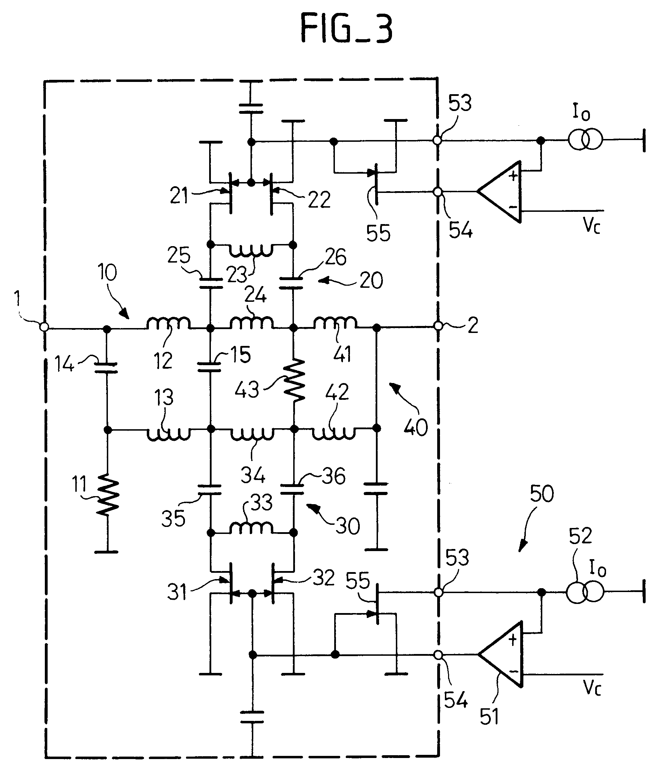

La figure 3 montre une réalisation intégrée monolithique appliquant ces différents enseignements, les composants illustrés étant tous formés sur un même substrat, selon la technologie bien connue des circuits MMIC (*Monolithic Microwave Integrated Circuit*).

Dans la réalisation illustrée, les coupleurs constituant les divers circuits 10, 20, 30 et 40 ont été réalisés à partir d'éléments à constantes localisées, mais les enseignements de l'invention pourraient également s'appliquer à une réalisation en composants à constantes réparties (par exemple dans le cas d'une réalisation en technologie microruban).

On retrouve sur cette figure les mêmes éléments que ceux schématisés figure 1, à savoir : le circuit diviseur 10, formé ici de deux éléments inductifs 12, 13 et de deux éléments capacitifs 14, 15 ; le circuit de modulation vectorielle 20, constitué de deux éléments inductifs 23, 24 et de deux éléments capacitifs 25, 26, le coupleur ainsi constitué étant relié aux deux résistances variables 21 et 22 (sur lesquelles on reviendra plus bas) ; le circuit de modulation vectorielle 30 constitué des éléments 31 à 36 homologues des éléments 21 à 26 du circuit 20 ; et enfin le circuit combiner 40, constitué des deux éléments inductifs 41 et 42 et de l'élément résistif 43.

Dans cette réalisation, les résistances 21, 22, 31, 32, sont constituées par des composants à effet de champ commandés en tension, identiques (c'est-à-dire présentant notamment la même largeur de grille), les composants 21 et 22 (de même que les composants 31 et 32) étant appariés et commandés par une tension commune de manière à présenter la même variation de résistance sur les deux accès du coupleur 20 (respectivement, 30) auquel ils sont reliés.

Les tensions de commande de chacun des circuits de modulation vectorielle sont produites par un circuit 50 respectif comprenant un circuit de linéarisation (qui peut être externe à la puce) avec un amplificateur opérationnel 51 recevant sur l'une de ses entrées une tension de commande $V_c$ et relié à son autre entrée à un générateur 52 de courant constant, l'ensemble étant relié comme illustré d'une part (borne 53) au drain d'un troisième transistor 55 intégré sur le substrat et d'autre part (borne 54) aux grilles des transistors 31 et 32, ainsi qu'à celle du transistor 55. Le transistor 55 joue le rôle d'une référence de tension coopérant avec le circuit de linéarisation 51, 52 de manière à rendre la résistance entre drain et source de chacun des transistors 21, 22 (ou 31, 32) parfaitement proportionnelle à la tension de commande $V_c$ appliquée sur la branche respective.

## Revendications

1. Un circuit déphaseur à modulation vectorielle, comprenant :

   — un circuit diviseur (10), recevant en entrée (1) un signal à déphaser et fractionnant celui-ci en deux signaux en quadrature délivrés sur deux sorties respectives,

   — monté sur chacune des sorties du circuit diviseur, un circuit de modulation vectorielle (20 ; 30), soumettant le signal fractionné respectif à une atténuation variable et à une inversion de phase éventuelle, et

   — un circuit combineur (40), recevant sur ses entrées les signaux délivrés par les circuits de modulation vectorielle respectifs et délivrant sur sa sortie (2) le signal déphasé,

   caractérisé en ce que chacun des circuits de modulation vectorielle est essentiellement constitué d'un atténuateur du type réflectif comprenant des moyens d'ajustement d'une valeur algébrique de l'atténuation, de manière à agir par une même commande sur l'amplitude et l'inversion éventuelle de phase du signal reçu en entrée.

2. Le circuit de la revendication 1, dans lequel l'atténuateur réflectif comprend un coupleur à quatre accès, avec un premier accès constituant l'entrée, un second accès constituant la sortie et les deux autres accès constituant des accès de commande reliés à deux charges résistives semblables (21,22 ; 31,32), ces charges étant variables et contrôlées par la même commande.

3. Le circuit de la revendication 2, dans lequel les charges résistives comprennent un montage différentiel de transistors à effet de champ commandés en tension, et dont les bornes homologues sont reliées aux accès de commande respectifs du coupleur.

4. Le circuit de la revendication 3, comprenant en outre un circuit (50) de linéarisation de la variation de résistance en fonction de la tension de commande des transistors à effet de champ.

FIG_1

FIG_2

# FIG_3

EP 0 511 886 A1

Office européen
des brevets

**RAPPORT DE RECHERCHE EUROPEENNE**

Numero de la demande

EP 92 40 0995

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | US-A-4 737 739 (C.D. ROSIER E.A.) 12 Avril 1988 <br> * colonne 4, ligne 6 - colonne 5, ligne 17; figures 3,4 * <br> --- | 1,2 | H03H11/20 |
| Y | ELECTRONICS LETTERS. <br> vol. 16, no. 14, Juillet 1980, ENAGE GB <br> pages 553 - 554; <br> C.TSIRONIS E.A.: 'DUAL GATE GaAs MESFET PHASE SHIFTER WITH GAIN AT 12 GHz' <br> * le document en entier * <br> --- | 1,2 | |
| A | US-A-4 153 886 (HOTZE MIEDEMA) 8 Mai 1979 <br> * le document en entier * <br> <br> ----- | 1 | |

| DOMAINES TECHNIQUES RECHERCHES (Int. Cl.5) |
|---|
| H03H <br> H01P |

Le présent rapport a été établi pour toutes les revendications

| Lieu de la recherche | Date d'achèvement de la recherche | Examinateur |
|---|---|---|
| LA HAYE | 06 AOUT 1992 | COPPIETERS C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.............................................................................................
& : membre de la même famille, document correspondant

EPO FORM 1503 03.82 (P0402)

7